# EUROPEAN PATENT SPECIFICATION

(11) **EP 2 218 522 B1**
(45) Date of publication and mention of the grant of the patent: **26.10.2011**
(21) Application number: 10004817.2
(22) Date of filing: 07.05.2003
(51) Int. Cl.: B08B 3/02, H01L 21/00

(54) **Method and device for local treatment of substrates**
Verfahren und Vorrichtung zur lokalen Behandlung von Substraten
Procédé et dispositif pour le traitement local de substrats

(30) Priority: 07.05.2002 AU PS212502
(43) Date of publication of application: 18.08.2010
(62) Divisional of application: 03720014.4
(73) Proprietor: Dyesol Ltd, Subiaco, WA 6008 (AU)
(72) Inventor: Bertoz, Michael, Peter, John, Flynn ACT 2615 (AU); Skryabin, Igor, Lvovich, Yarralumla ACT 2600 (AT)
(74) Representative: Manitz, Finsterwald & Partner GbR

(56) References cited:
- GB-A- 2 368 314
- US-A- 3 915 739
- US-A1- 2001 027 806

## Description

### TECHNICAL FIELD

This invention relates to methods and devices for treatment of substrates (cleaning, priming, etc...). Substrates described in this invention may have one or more layers deposited over their surfaces before the treatment.

More particularly, the invention relates to the methods of a process for manufacturing a working electrode for use in Dye Solar Cells (DSC). Such a process is described in US 2001/027806 A1.

### BACKGROUND TO THE INVENTION

Methods for treatment of substrates with fluids usually comprise the 3 following stages:
1. Delivery of fluid to a substrate.
2. Allowing fluid to interact with surface of the substrate.
3. Removal of fluid (that may contain products of interaction (2)) from the substrate Examples of delivering fluid to a substrate described in the prior art include:
   - Dipping substrates in fluid
   - Spraying liquid over surface of the substrates
   - Wiping substrates using wet materials
Examples of removal of fluid from the substrate include:
- Dipping in or spraying with another fluid,
- Wiping substrates with dry material or material wetted by another fluid
- Using substantial pressure in gas phase (for example: gas jet) to remove the fluid.

Application of one or more of the above methods for treatment of local areas of a substrate usually involves masking the substrates in such a way that fluid is allowed to contact only the said local areas. However, the masking is often inconvenient and may compromise the integrity of the product.

There therefore exists a need for a method of locally treating substrates without prior masking.

### SUMMARY OF THE INVENTION

This need is met by a method comprising the features of claim 1. The present invention is based on realisation that local treatment of substrates with fluids can be achieved in a continuous process that comprises simultaneous delivery of a fluid to and removal of the fluid from the local preselected areas of a substrate.

One aspect of the present invention provides for directing a fine jet of fluid towards the local areas of a substrate and simultaneously applying vacuum suction force to the said areas. Both said fine jet of fluid and said vacuum suction force are tuned in such a way that:
• the fluid is allowed to interact with the said local preselected area of the substrate;
In one embodiment in accordance with this aspect of the invention, to ensure that the said fluid does not interact with areas of a substrate other then the said local preselected areas, said vacuum suction force is applied to any of the said preselected local areas in such a way that the said fluid is removed from the said local preselected area in a direction perpendicular to that area in a close proximity from the substrate. However, after the fluid has been removed, further displacement of the said fluid is not necessarily perpendicular to that local preselected area.
• In another embodiment in accordance with this aspect of the invention, to ensure that the said fluid does not interact with areas of a substrate when interaction is completed, the fluid and possible products of the interaction are completely or partially removed from the substrate.
other then the said local preselected areas, the said fluid jet is directed perpendicularly to any of the said preselected local areas.

In still another embodiment in accordance with this aspect of the invention the said interaction between said fluid and substrate results in dissolution of undesirable compounds on the surface of the substrate in the said fluid. In this case (local cleaning by dissolution) chemical composition of the said fluid is adjusted to ensure effective dissolution when prior knowledge of the chemical composition(s) of the said undesirable compounds is available.

In yet another embodiment in accordance with this aspect of the invention, the said interaction between said fluid and substrate results in mixing of the said fluid with undesirable small solid particles on surface of the substrate, thus the said particles are effectively removed from the substrate along with the said fluid. This describes local cleaning by mixing.

In still another embodiment in accordance with this aspect of the invention, the said interaction between said fluid and substrate results in dissolution of material that forms the surface of the substrate. In this way local etching or grooving is achieved.

In still another embodiment in accordance with this aspect of the invention, the said interaction between said fluid and substrate results in changing chemical properties of surface of the substrate, thus in preparation of the said local preselected areas of the substrate for further processing

In still a further embodiment in accordance with this aspect of the invention, the said interaction between said fluid and substrate results in formation of an additional layer on surface of the substrate. In this case part of the said fluid remains on the local preselected area of substrate to form an additional layer (for example, by sol-gel process), whereas excess of the fluid is removed by action of the said vacuum suction force.

In still another embodiment in accordance with this aspect of the invention, the said fluid is the dye removal solution (e.g. ammonium hydroxide solution in water), said substrate is a glass substrate coated by a transparent electronic conductor (TEC) to be used in deposition of electrodes for Dye

Solar Cells (DSC), some areas of the substrate having subsequently been coated by one or more layers at least one of which is a nanoporous layer of titanium dioxide or other semiconducting material, and the whole area of the substrate having been coated by dye ; local preselected areas of the substrate are those that are coated by dye, but are not coated by other layers. Removal of the dye from the local preselected areas and possible treatment of these areas creates conditions for subsequent application of further layers of DSC, such as, for example interconnecting and sealing material.

In one embodiment in accordance with this aspect of the invention the said fluid comprises liquid phase or gas phase or a mixture thereof.

In a further embodiment in accordance with this aspect of the invention the said fluid comprises vapour that condenses on to the said local preselected areas. In this case said fluid is delivered in gas phase, but the interaction between said fluid and said local preselected area of substrate takes place when the said fluid is in liquid phase.

In still a further embodiment in accordance with this aspect of the invention two or more jets of different fluids directed towards local preselected areas of the substrate. The said interaction in this case is between 1^{st} fluid, 2^{nd} fluid, etc, and the substrate. Excess of the fluids and products of interaction (where applicable) are removed from the said local areas by action of the said vacuum suction force.

The invention can be utilised in both static and dynamic mode. In the static mode size and shape of said fluid jet resemble that of the said local area. Application of the said jet to the said local area under simultaneous action of said vacuum suction force allows for precise treatment of the said local area. In the dynamic mode size of the said fluid jet is smaller than that of the said local area. At any given instant of time the said fluid jet is applied only to a portion of said local preselected area. Treatment of the whole local area is achieved by movement of said fluid jet with respect to the said local area. Typically, the fluid jet acts within the area to which the vacuum suction force is applied. The invention also provides for the fluid jet to be followed by the vacuum suction force.

The following parameters can be adjusted to ensure effective treatment in the static mode:
- Chemical composition of the fluid
- Velocity of the fluid
- Temperature of the fluid
- Temperature of the substrate
- Size and shape of the fluid jet
- Direction of the fluid jet (normal or oblique to the substrate)
- Size and shape of a region to which vacuum suction force is applied
- Direction of the vacuum suction force (normal or oblique to the substrate)
- Value of the vacuum suction force (pressure differential)
- Duration of application of fluid jet
- Duration of application of vacuum suction force
- Synchronisation between application of the said fluid jet and said vacuum suction force.

In addition to the above parameters, in the dynamic mode the following parameters can be adjusted to ensure effective treatment:
- Speed of motion of the said fluid jet with respect to the said substrate
- Synchronisation between applications of the said fluid jet, said vacuum suction force and position of the said jet with respect to the said local area of substrate.

Another aspect of the present invention provides for a device for local treatment of substrates; the device comprises means for creation of fluid jet(s) and means for removing fluid from the local preselected area of the substrate by action of a vacuum suction force. The said means for creation of fluid jet(s) comprise container(s) with fluid(s), source of pressure, fluid delivery pipes and nozzle(s) for release of fluid jet(s). The said means for removing fluid comprise vacuum pump, vacuum pipes and vacuum nozzle for precise application of the said vacuum suction force to the said local areas of substrate.

In one embodiment in accordance with this aspect of the invention said device contains additional means for precise positioning of the said vacuum and fluid nozzles with respect to the local preselected areas of the substrate. The said precise positioning include positioning in X-Y direction, where X-Y is a plane that approximates a local preselected area of the substrates; and in Z. direction, perpendicular to the local preselected area of the substrate.

In another embodiment in accordance with this aspect of the invention said device additionally contains means for uniform movement of said jet and vacuum nozzles with respect to the substrate. For 2-D substrates this movement takes place in one plane, for 3-D substrate this movement takes place in 3-D.

In still another embodiment in accordance with this aspect of the invention the said device additionally contains valves in both fluid delivery and fluid removal lines to commence/terminate fluid jet(s) and/or application of vacuum suction force in accordance with position of the said vacuum and fluid nozzles with respect to the local preselected area of the substrate.

In yet another embodiment in accordance with this aspect of the invention, size of the said vacuum nozzle is larger than that of the fluid nozzle, the fluid nozzle is placed within the said vacuum nozzle, space inside the said liquid nozzle is used to create the said fluid jet, space between fluid and vacuum nozzle is used to transfer said vacuum suction force to the said local preselected areas of a substrate.

In yet another embodiment in accordance with this aspect of the invention, the shape of said vacuum nozzle is similar to that of the fluid nozzle and both nozzles are concentric.

In further embodiment in accordance with this aspect of the invention the said fluid delivery means comprise 2 or more concentric fluid nozzles for delivery of 2 or more fluids.

In one embodiment in accordance with this aspect of invention the said device additionally comprise means for in-situ controlling treatment of said local preselected areas.

In a further embodiment in accordance with this aspect of the invention said in-situ control means comprise a stable light source and a light detector; light emitted by the said light source is focused on part of the local preselected area, light detector measures the intensity of light reflected from the said part (or alternatively, the light transmitted through the said part), electrical signal generated by the said light detector serves as a measure of effectiveness and completeness of the said treatment and as a control signal for in-situ adjustment of the process parameters (such as for example, distance between nozzles and substrate, speed of motion of the nozzles with respect to the substrate, vacuum suction, fluid pressure).

In still a further embodiment in accordance with this aspect of invention said in-situ controls means comprise a sensor to monitor chemical composition of the removed fluid; said sensor being positioned in the said fluid removal line. Deviation of the said chemical composition from predetermined reference value serves as a measure of effectiveness and completeness of the said treatment.

### BRIEF DESCRIPTION OF DRAWINGS

Halving broadly portrayed the nature of the present invention, embodiments thereof will now be described by way of example and illustration. In the following description, reference will be made to the accompanying drawings in which:
Figure 1 Demonstrates a principle for the local treatment of substrates
Figure 2 is a cross sectional view of device that includes optical in-situ monitoring
Figure 3 is a cross sectional view of the device with dual fluid supply
Figure 4a is a schematic representation of an electrode for Dye Solar cell to be treated using this invention
Figure 4b is a schematic representation of an electrode for Dye Solar cell after local dye removal.
Figure 5 is a schematic representation of fluid supply and fluid removal systems of the device
Figure 6 is a schematic representation of an electronic control system of the device.

### DETAILED DESCRIPTION OF DRAWINGS

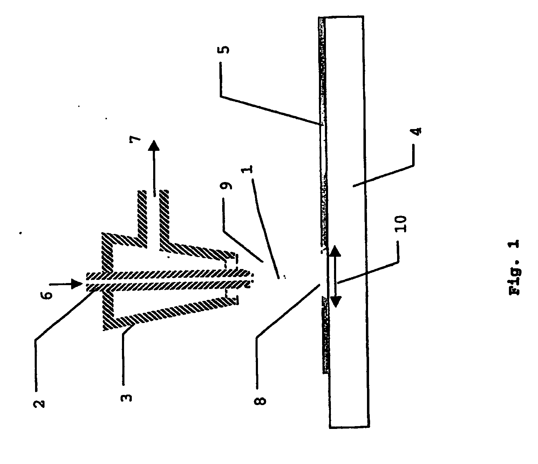

Referring to Figure 1, this diagram demonstrates the principle of the local treatment of substrates. A fluid nozzle 2 creates a fine fluid jet 1 directed perpendicularly to a substrate 4. Surface of the substrate 4 contains an undesirable compound 5, which is to be removed from a local preselected area 10. The undesirable compound 5 is dissolved in fluid delivered to the local preselected area 10 by the fluid jet. The fluid and products of interaction 8 are removed from the area 10 by action of the vacuum suction force 9 created by a vacuum nozzle 3. The fluid is delivered from a fluid supply system 6 and finally removed to a fluid removal system 7.

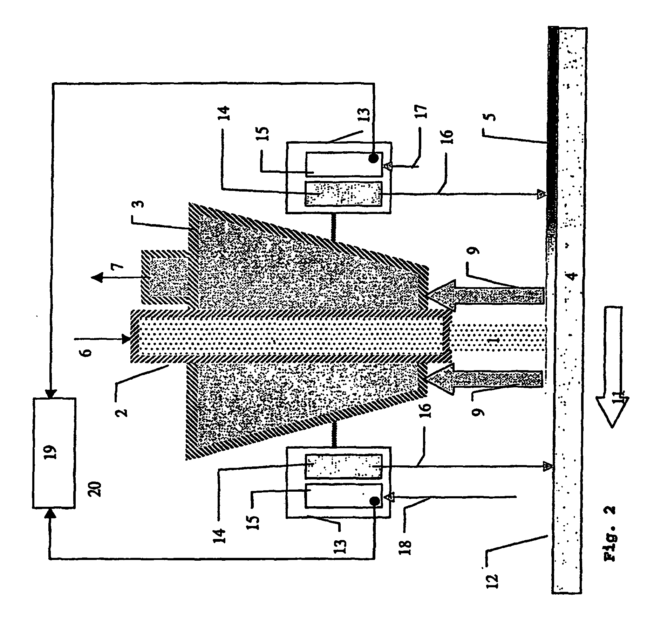

Referring to Figure 2, this diagram demonstrates removal of an undesirable compound 5 from a substrate 4 in a dynamic mode along a thin straight line. In this example the substrate is moved in direction 11, thus the left hand side 12 of the substrate surface has already been treated, whereas the right hand side 5 is to be treated. The cleaning process is controlled by two optical sensors 13. Each optical sensor comprises a stable light source 14 and a light detector 15. Each light source generates a standard fight ray 16 incident to the substrate. Intensity of light reflected from the treated area 18 is higher than that reflected from the untreated area 17. Each light detector converts light intensity into an electrical signal. The electrical signals from the detectors are transmitted to a comparator 19. The comparator compares electrical signals from the light detectors and generates a control signal 20. The control signal is used by a process control system to adjust the process parameters (speed of substrate, pressure in fluid supply, etc...) in situ in order to maintain quality of the local treatment.

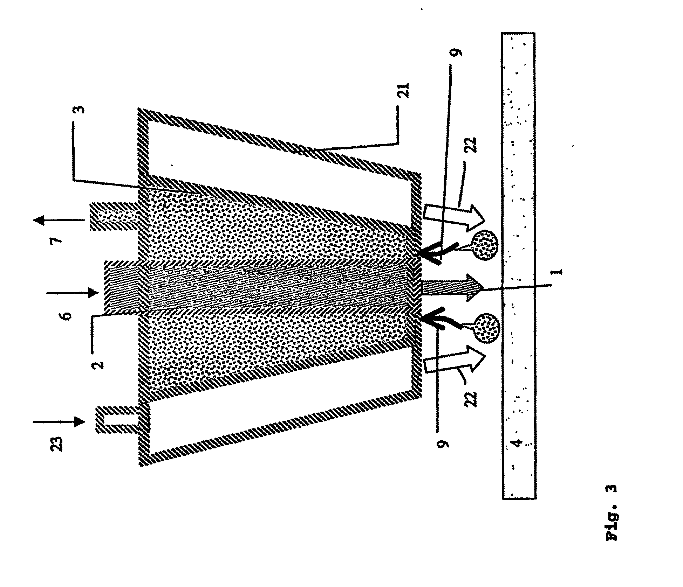

Referring to Figure 3, a cross-sectional view of dual fluid supply system is presented. The system comprises a first fluid nozzle 2 to create a first fluid jet 1, a vacuum nozzle 3 to create a vacuum suction force 9 and a second fluid nozzle 21 to create a second fluid jet 22.
The first fluid is supplied from the first fluid supply system 6 and the second - from the second fluid supply system 23.

Both fluids are delivered to a local preselected area of a substrate 4, where the fluids interact between each other and with the surface of the substrate. This interaction results in treatment of the local preselected area of the substrate. Products of the interaction 8 are removed from the substrate by the action of vacuum suction force 9 through the vacuum nozzle 3 to a fluid removal system 7.

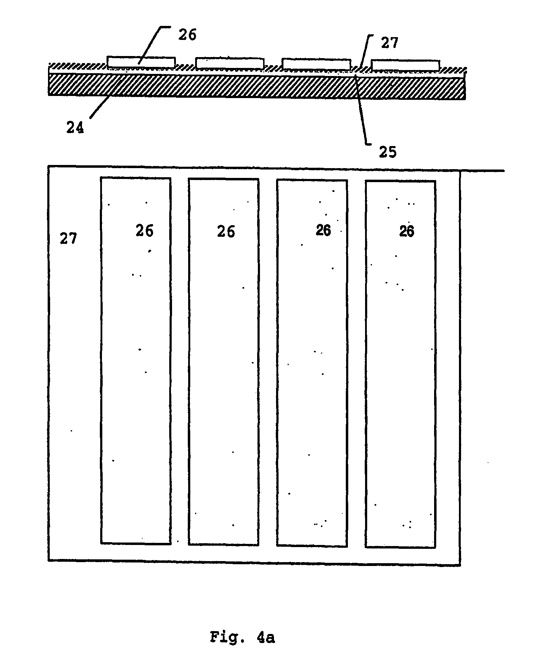

Referring to Figure 4a, a cross-sectional and a planar view of a working electrode for Dye Solar (DSC) cell are presented. The electrode comprises a glass substrate 24, Transparent Electronic Conductor (TEC) layer 25 and a nanoporous layer of titanium dioxide 26. The whole area of the electrode is covered by dye 27. Local preselected areas of the substrate are those that are coated by dye, but are not coated by titanium dioxide.

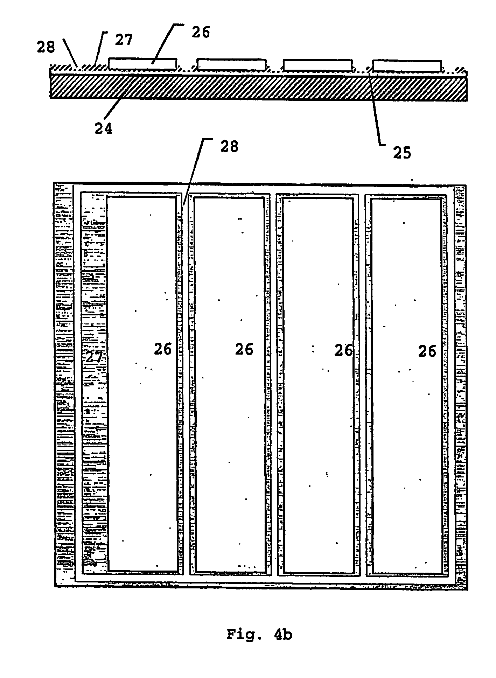

Referring to Figure 4b, cross-sectional and planar views of the working electrode for DSC (refer to Fig. 4a) after process of local dye removal are presented. Required pattern of a local preselected area 28 (2 mm wide) is now clean and ready for subsequent application of further layers of DSC, such as, for example interconnecting and sealing material.

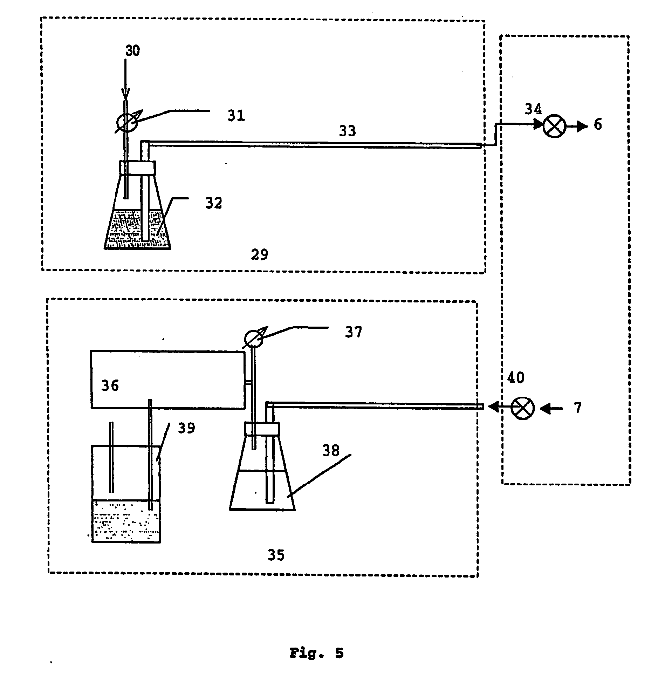

Referring to Figure 5, a fluid supply and a fluid removal system of a device for local treatment of substrates are presented. The fluid supply sytem 29 comprises compressed gas supply 30, compressed gas gauge 31, container with the fluid 32, fluid supply pipe 33 and fluid supply electromagnetic valve 34. The fluid removal system 35 comprises vacuum pump 36, vacuum gauge 37, removed fluid tank 38, scrubbing tank 39 and fluid removal electromagnetic valve 40.

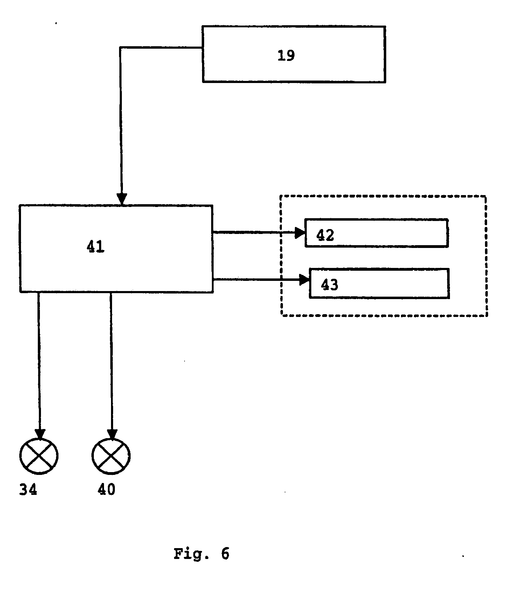

Referring to Figure 6, an electronic control system of the device for local treatment of substrates is presented.
The system comprises a computer 41, a comparator 19, X-stage 42, Y- stage 43. The computer progam drives X-Y stages in accordance with a pattern of the local preselected areas on a substrate. The computer also controls supply and removal of the fluids by opening and closing electromagnetic valves 34 and 40. The comparator 19 generates a differential electrical signal that is used by the computer to adjust treatment parameters.

### Examples

5 examples of the invention are presented in Figures 2-6.

## Claims

1. A process for fabricating a working electrode for use in a Dye Solar Cell (DSC), the method including the steps of:
providing a transparent substrate (24) with a Transparent Electronic Conductor (TEC) layer (25) ;
coating an area of the TEC layer (25) with a layer of semiconducting material (26); and
applying a layer of dye (27) over both the Transparent Electronic Conductor (TEC) layer (25) an the layer of semiconducting material (26);
**characterized by**
locally treating the substrate with a fluid, the fluid being selected to dissolve the dye (27);
said process comprising creating and directing at least one jet of fluid towards local areas of the substrate; the local areas being coated by dye, but not coated by the semiconducting material and applying a vacuum suction force to the said local areas.

2. A method according to claim 1 wherein said fluid comprises a solution of ammonium hydroxide.

3. A method to either claim 1 or 2 wherein the semiconducting layer includes titanium dioxide.

4. A method according to any preceding claim further including the step of applying interconnecting or sealing material to the local areas.

5. A method according to any preceding claim wherein at any given time, said fluid jet is applied only to a portion of said local area.

## Patentansprüche

1. Prozess zur Herstellung einer Arbeitselektrode zur Verwendung in einer Farbstoffsolarzelle (DSC), wobei das Verfahren die Schritte umfasst, dass:
ein transparentes Substrat (24) mit einer Schicht (25) eines transparenten elektronischen Leiters (TEC) versehen wird;
ein Bereich der TEC-Schicht (25) mit einer Schicht aus halbleitendem Material (26) beschichtet wird; und
eine Schicht aus Farbstoff (27) über sowohl der Schicht (25) eines transparenten elektronischen Leiters (TEC) als auch der Schicht aus halbleitendem Material (26) aufgetragen wird;
**dadurch gekennzeichnet, dass**
das Substrat lokal mit einem Fluid behandelt wird, wobei das Fluid so gewählt ist, dass es den Farbstoff (27) löst;
wobei der Prozess ein Erzeugen und Lenken zumindest eines Fluidstrahls zu lokalen Bereichen des Substrats; wobei die lokalen Bereiche mit Farbstoff beschichtet sind, jedoch nicht mit dem halbleitenden Material beschichtet sind, und Aufbringen einer Vakuumsaugkraft auf die lokalen Bereiche umfasst.

2. Verfahren nach Anspruch 1, wobei das Fluid eine Lösung aus Ammoniumhydroxid umfasst.

3. Verfahren nach einem der Ansprüche 1 oder 2, wobei die halbleitende Schicht Titandioxid umfasst.

4. Verfahren nach einem der vorhergehenden Ansprüche, ferner mit dem Schritt, dass ein verbindendes oder abdichtendes Material auf die lokalen Bereiche aufgetragen wird.

5. Verfahren nach einem der vorhergehenden Ansprüche, wobei zu einem gegebenen Zeitpunkt der Fluidstrahl nur auf einen Abschnitt des lokalen Bereiches aufgebracht wird.

## Revendications

1. Procédé pour fabriquer une électrode de travail à utiliser dans une cellule solaire à teinture ("Dye Solar Cell"), le procédé incluant les étapes consistant à :
fournir un substrat transparent (24) avec une couche conductrice électronique transparente (TEC) (25) ;
revêtir une zone de la couche conductrice électronique transparente TEC (25) avec une couche de matériau semi-conducteur (26) ; et
appliquer une couche de teinture (27) à la fois sur la couche conductrice électronique transparente (TEC) (25) et sur la couche de matériau semi-conducteur (26) ;
**caractérisé par** l'étape consistant à
traiter localement le substrat avec un fluide, le fluide étant sélectionné pour dissoudre la teinture (27) ;
ledit procédé comprenant l'étape consistant à produire et à diriger au moins un jet de fluide vers des zones localisées du substrat ; les zones localisées étant revêtues de teinture, mais n'étant pas revêtues de matériau semi-conducteur, et à appliquer une force de succion sous vide auxdites zones localisées.

2. Procédé selon la revendication 1, dans lequel ledit fluide comprend une solution d'hydroxyde d'ammonium.

3. Procédé selon l'une ou l'autre des revendications 1 ou 2, dans lequel la couche semi-conductrice inclut du dioxyde de titane.

4. Procédé selon l'une quelconque des revendications précédentes, incluant en outre l'étape consistant à appliquer un matériau d'interconnexion ou de scellement aux zones localisées.

5. Procédé selon l'une quelconque des revendications précédentes, dans lequel à un quelconque instant donné ledit jet de fluide est appliqué uniquement à une portion de ladite zone localisée.
